# EUROPÄISCHE PATENTSCHRIFT

(11) **EP 3 973 305 B1**
(45) Veröffentlichungstag und Bekanntmachung des Hinweises auf die Patenterteilung: **22.05.2024**
(21) Anmeldenummer: 20746884.4
(22) Anmeldetag: 10.07.2020
(51) Int. Cl.: G01R 31/42, G01R 31/71

(54) **VERFAHREN UND VORRICHTUNG ZUR DETEKTION VON ALTERUNGSBEDINGTEN SCHÄDEN ODER DELAMINATIONEN AN BAUTEILEN, INSBESONDERE LEISTUNGSMODULEN LEISTUNGSELEKTRONISCHER GERÄTE SOWIE LEISTUNGSELEKTRONISCHES GERÄT, INSBESONDERE UMRICHTER**
METHOD AND APPARATUS FOR DETECTING AGE-RELATED DAMAGE OR DELAMINATION ON COMPONENTS, IN PARTICULAR POWER MODULES OF POWER ELECTRONIC DEVICES, AND POWER ELECTRONIC DEVICE, IN PARTICULAR CONVERTER
PROCÉDÉ ET DISPOSITIF DE DÉTECTION DE DÉTÉRIORATIONS DUES AU VIEILLISSEMENT OU DÉLAMINATION SUR LES COMPOSANTS, EN PARTICULIER LES MODULES DE PUISSANCE D'APPAREILS ÉLECTRONIQUES DE PUISSANCE ET APPAREIL ÉLECTRONIQUE DE PUISSANCE, EN PARTICULIER CONVERTISSEUR

(30) Priorität: 25.07.2019 DE 102019211104
(43) Veröffentlichungstag der Anmeldung: 30.03.2022
(73) Patentinhaber: Siemens Aktiengesellschaft, 80333 München (DE)
(72) Erfinder: MITIC, Gerhard, 81827 München (DE); BAUMGARTNER, Robert, 82178 Puchheim/Bhf. (DE); HONSBERG, Martin, 83109 Großkarolinenfeld (DE)
(74) Vertreter: Siemens Patent Attorneys
(86) Internationale Anmeldenummer: PCT/EP2020/069580
(87) Internationale Veröffentlichungsnummer: WO 2021/013586

(56) Entgegenhaltungen:
- DE-A1-102014 204 893
- DE-A1-102015 202 077
- DE-A1-102016 201 788
- DE-A1-102017 109 398

## Beschreibung

Die Erfindung bezieht sich auf ein Verfahren zur Detektion von alterungsbedingten Schäden oder Delaminationen an Bauteilen, insbesondere Leistungsmodulen leistungselektronischer Geräte gemäß dem Oberbegriff des Patentanspruches 1, eine Vorrichtung zur Detektion von alterungsbedingten Schäden oder Delaminationen an Bauteilen, insbesondere Leistungsmodulen leistungselektronischer Geräte gemäß dem Oberbegriff des Patentanspruches 6 und ein Leistungselektronisches Gerät, insbesondere Umrichter, gemäß dem Oberbegriff des Patentanspruches 13.

Das altersbedingte Entstehen von Schäden oder Delaminationen ist grundsätzlich an Bauteilen der unterschiedlichsten Werkstoffbeschaffenheit oder -zusammensetzung zu beobachten, die in einer gegebenen Einsatz- oder Betriebsumgebung kontinuierlichen oder sich zyklisch ändernden physikalischen Belastungen ausgesetzt sind. So unterliegen Leistungsmodule, wie z.B. "Insulated-Gate Bipolar-Transistor <IGBT>"-Module, in leistungselektronischen Geräten, wie z.B. einem Umrichter, einer Alterung durch den normalen Betrieb innerhalb ihrer spezifizierten Betriebsgrenzen. Diese Alterung wird hauptsächlich durch eine hohe Zahl von Lastzyklen der Betriebserwärmung und -abkühlung hervorgerufen, die zur allmählichen Zerstörung von Chiplotschichten unter den Halbleiterchips und zur Ermüdung von Bonddrähten und Chipmetallisierungen führen, die den Strom in die schaltenden und gleichrichtenden Chips leiten. Typische, sich dabei einstellende Fehlermechanismen sind Bond Lift-Off, Heel-Crack und Lotermüdung von Chip- und Systemlot.

Deshalb ist eine zuverlässige Alterungsbestimmung von Bauteilen, insbesondere von Leistungsmodulen in leistungselektronischen Geräten, wie Umrichtern, von Interesse, die eine ausreichend genaue Prognose für die noch verbleibende Betriebslebensdauer zulässt.

Mit Hilfe eines Radars ist es möglich die alterungsbedingten elektrischen und mechanischen Änderungen nachzuweisen. Hierzu muss die Änderung von Reflexionen des Bauteils bzw. Leistungsmoduls im Mikrowellen- oder Millimeterwellenbereich über einen Zeitraum von bis zu 30 Jahren überwacht werden. Die Radarsysteme sind im Allgemeinen jedoch nicht über diesen Zeitraum langzeitstabil, so dass ein Vergleich einer HF-Referenzmessung mit einer Messung im gealterten Betriebszustand nicht möglich ist. Eine zuverlässige Alterungsbestimmung ist wegen der Drift des Radarsystems daher nicht ohne weiteres möglich.

In Einsatzgebieten, in denen ein Ausfall eines Bauteils bzw. Leistungsmoduls unbedingt vermieden werden muss, so z.B. bei Umrichter in Off-Shore-Windparks, bei Traktionsanwendungen, etc., gibt es verschiedene Lösungswege durch Redundanz bzw. präventiven Austausch auf der Wartungsebene, Bauteil- bzw. Leistungsmodulausfällen zu begegnen. Mit Hilfe von thermischen Modellen und beschleunigter Lebensdauerprüfung kann dabei auf die zu erwartende und die bereits verbrauchte Lebensdauer geschlossen werden. Aufgrund der verwendeten Modelle sind diese Berechnungen jedoch mit großen Fehlern behaftet.

Im Fall von Leistungsmodulen werden von einigen Leistungsmodulherstellern beispielsweise IGBT-Module angeboten die Dioden, integriert als Temperatursensoren IGBT-Chips, enthalten. Indirekt über die Temperaturerhöhung der "Insulated-Gate Bipolar-Transistoren <IGBT`s>" lässt sich damit auf eine Alterung schließen.

Für eine Zustandsüberwachung von Leistungsmodulen in Umrichtern im Hinblick auf eine Lebensdauerprognose gibt es bislang keine kommerzielle Lösung.

Zur Kompensation einer Drift bei HF-Netzwerkanalysatoren werden zwar Kalibriereinrichtungen angeboten, die vor jeder Messung das System neue kalibrieren. Allerdings kommerzielle Radaranwendungen mit einer Langzeitstabilität von mehreren Jahren gibt es aktuell nicht.

Aus der DE 10 2014 204893 A1 ist ein Verfahren und eine Vorrichtung zur Alterungsbestimmung eines leistungselektronischen Schaltmoduls bekannt, bei dem bzw. der eine noch verbleibende Betriebslebensdauer des leistungselektronischen Schaltmoduls prognostiziert werden kann, indem
- Hochfrequenzmesssignale erzeugt werden, die jeweils eine Messsignalfrequenz von mehr als 100 MHz aufweisen,
- die erzeugten Hochfrequenzmesssignale an mindestens einem Messpunkt des leistungselektronischen Schaltmoduls eingekoppelt, wobei die eingekoppelten Hochfrequenzmesssignale innerhalb des leistungselektronischen Schaltmoduls reflektiert werden,
- die reflektierten Hochfrequenzmesssignale zur Ermittlung von Reflexionssignalsignaturen des leistungselektronischen Schaltmoduls ausgewertet werden und
- die Reflexionssignalsignaturen zur Erkennung einer für einen Alterungsprozess des leistungselektronischen Schaltmoduls charakteristischen Veränderung der Reflexionssignalsignaturen vergleichen werden.

Aus der DE 10 2015 202077 A1 ist ein Verfahren zum Bestimmen eines Schädigungsgrades eines Leistungshalbleitersystems bekannt, bei dem die Alterung der Leistungshalbleitersysteme zuverlässiger bestimmt und dadurch eine Restlebensdauer der Leistungshalbleitersysteme genauer vorhergesagt werden kann, indem
- ein Hochfrequenzsignal vorgegeben wird, dessen Signalfrequenz einen vorgegebenen Hochfrequenzbereich durchläuft,
- ein Referenz-Streuparameterspektrum zu einem Referenzzeitpunkt, welches ein Reflexions- und/oder Transmissionsverhalten des Leistungshalbleitersystems beschreibt, durch Bestimmen
eines jeweiligen Verhältnisses des an dem Signaleingang eingespeisten Hochfrequenzsignals zu einem an dem Signalausgang empfangenen Referenzreflexions- und/oder Referenztransmissionssignal bei den jeweiligen Signalfrequenzen des eingespeisten Hochfrequenzsignals erzeugt wird,
- ein aktuelles Streuparameterspektrum zu zumindest einem gegenüber dem Referenzzeitpunkt späteren Zeitpunkt durch Bestimmen eines jeweiligen Verhältnisses des an dem Signaleingang eingespeisten Hochfrequenzsignals zu einem an dem Signalausgang empfangenen aktuellen Reflexions- und/oder Transmissionssignal bei den jeweiligen Signalfrequenzen des eingespeisten Hochfrequenzsignal erzeugt wird,
- ein Differenz-Streuparameterspektrum ermittelt wird, welches einen Unterschied zwischen dem Referenz-Streuparameterspektrum und dem aktuellen Streuparameterspektrum beschreibt,
- ein Schadensindikator anhand des Differenz-Streuparameterspektrums bestimmt wird und
- ein Schädigungsgrad des Leistungshalbleitersystems (1) anhand des Schadensindikators bestimmt wird.

Aus der DE 10 2016 201788 A1 ist ein Verfahren und eine Vorrichtung zur Überwachung der Lebensdauer von zumindest von Teilelementen elektronischer Schaltungen bekannt, bei dem bzw. der eine Alterungsbestimmung von Leistungsmodulen, wie z.B. Umrichtern, ermöglicht wird, indem
eine Anordnung einer Vielzahl von Antennen derart in der Nähe der Teilelemente platziert und betrieben wird, dass in die Teilelemente ein durch ein, elektrisches und/oder magnetisches Feld der Antennen derart einwirkt, dass hierdurch kontaktlos elektrische Größen, insbesondere elektrischer Strom und/oder Potenzialdifferenzen, in den Teilelementen erzeugt wird, wobei auf Grundlage der induzierten elektrischen Größen zumindest eine mit der Lebensdauer korrelierende physikalische Größe ermittelt wird.

Die der Erfindung zugrundeliegende Aufgabe besteht darin, ein Verfahren und eine Vorrichtung zur Detektion von alterungsbedingten Schäden oder Delaminationen an Bauteilen, insbesondere Leistungsmodulen leistungselektronischer Geräte sowie ein leistungselektronisches Gerät, insbesondere Umrichter, anzugeben, mit dem bzw. der eine zuverlässige Detektion der alterungsbedingten Schäden oder Delaminationen an den Bauteilen, wie z.B. an den Leistungsmodulen, die in den leistungselektronischen Geräten bzw. Umrichtern zum Einsatz kommen, möglich ist, die eine ausreichend genaue Prognose für die noch verbleibende Betriebslebensdauer des Bauteils bzw. des Leistungsmoduls zulässt.

Diese Aufgabe wird ausgehend von dem im Oberbegriff des Patentanspruchs 1 definierten dem Detektionsverfahren durch die im Kennzeichen des Patentanspruches 1 angegebenen Merkmale gelöst.

Darüber hinaus wird die Aufgabe ausgehend von der im Oberbegriff des Patentanspruchs 6 definierten Detektionsvorrichtung durch die im Kennzeichen des Patentanspruches 6 angegebenen Merkmale gelöst.

Außerdem wird die Aufgabe ausgehend von dem im Oberbegriff des Patentanspruchs 13 definierten Leistungselektronischen Gerät durch die im Kennzeichen des Patentanspruches 13 angegebenen Merkmale gelöst

Die der Erfindung gemäß den unabhängigen Ansprüchen 1, 6 und 13 zugrundeliegenden Idee besteht darin,
**1**) im Zuge von Hochfrequenzreflektometrie ein Bauteil, insbesondere ein Leistungsmodul, durch Hochfrequenzsignal-Einstrahlung im Mikro- oder Millimeterwellenbereich und durch Messen von mindestens einem an dem Bauteil infolge der Hochfrequenzsignal-Einstrahlung reflektierten Reflexionssignal punktuell, eindimensional oder zweidimensional zur Erzeugung, insbesondere auf der Basis von mathematischen Methoden zur Bildrekonstruktion, von mindestens einer ersten Hochfrequenzabbildung abzuscannen,
**2**) das Bauteil unmittelbar zeitversetzt zur Hochfrequenzsignal-Einstrahlung durch eine Kombination aus Ultraschallsignal-Einstrahlung und der Hochfrequenzsignal-Einstrahlung im Mikro- oder Millimeterwellenbereich sowie durch Messen von mindestens einem weiteren, an dem Bauteil infolge der Ultraschallsignal- und Hochfrequenzsignal-Einstrahlung reflektierten Reflexionssignal punktuell, eindimensional oder zweidimensional zur Erzeugung von mindestens einer zweiten Hochfrequenzabbildung abzuscannen sowie
**3**) die auf der Grundlage der Reflexionssignale erzeugten Hochfrequenzabbildungen zu vergleichen, wobei festgestellte Veränderungen in den Hochfrequenzabbildungen Schäden oder Delaminationen am Bauteil indizieren.

Insbesondere bei Leistungsmodule erfolgt die Alterung graduell über Jahrzehnte des elektrischen Betriebs. Erfindungsgemäß sollen vorzugsweise bei der Kombination aus der Ultraschallsignal-Einstrahlung und der Hochfrequenzsignal-Einstrahlung im Mikro- oder Millimeterwellenbereich die an dem Leistungsmodul reflektierten Reflexionssignale bei dieser Kombination aus der Ultraschallsignal-Einstrahlung und der Hochfrequenzsignal-Einstrahlung, also unter Ultraschallanregung, gemessen und mit einer zeitlich darauffolgenden HF-Messung, bei der ausschließlichen das Hochfrequenzsignal ein gestrahlt wird, also keine Ultraschallanregung stattfindet, verglichen werden.

Die dadurch beobachteten Veränderungen der Reflexionssignale und Hochfrequenzabbildungen sind dabei unmittelbar sensitiv zu den Schäden oder Delaminationen im Leistungsmodul. Da die Messungen zeitlich unmittelbar hintereinander erfolgen ist keine aufwendige Driftkorrektur eines die Messungen durchführenden HF-Messsystems erforderlich, Änderungen der Reflexionssignale und Hochfrequenzabbildungen korrelieren unmittelbar mit den Schäden oder Delaminationen im Leistungsmodul und lassen so auf eine Alterung schließen. Die Alterung des Leistungsmoduls erfolgt hauptsächlich am Ort der Leistungshalbleiter, z.B. dem IGBT-Chip bzw. der Diode).

Die Ultraschallbasierte Einstrahlung erfolgt mit einer Frequenz von typisch 10-200 kHz wohingegen die Hochfrequenzsignal-Einstrahlung schmalbandig im mehrstelligen GHz-Bereich passiert. Die kombinierte Wechselwirkung von Ultraschall mit Hochfrequenz lässt sich dabei als Seitenband des Hochfrequenzsignals detektieren.

Für die Ultraschallsignal-Einstrahlung, die vorzugsweise gemäß der Ansprüche 5 und 12 unmittelbar im Bodenbereich des Leistungsmoduls passiert, wird gemäß der Ansprüche 4 und 11 bevorzugt mindestens eine Sonotrode benutzt.

Die Ultraschallsignal-Einstrahlung ist sehr sensitiv in Bezug auf lokale Risse in den Verbindungsschichten des Leistungsmoduls, insbesondere der Lötungen und Bondungen. Abhängig von den Ermüdungen in den Verbindungsebenen der Bondungen und Lötungen werden diese Schädigungsebenen zu verschiedenen lokalen geometrischen Schwingungen im Ultraschallbereich angeregt. Das Abscannen durch die Hochfrequenz-Einstrahlung im Mikro- oder Millimeterwellenbereich, bei dem vorzugsweise auf der Basis von mathematischen Methoden zur Bildrekonstruktion die beiden Hochfrequenzabbildungen, einmal ohne die Ultraschallsignal-Einstrahlung im Fall der der ersten Hochfrequenzabbildung sowie einmal mit der Ultraschallsignal-Einstrahlung im Fall der der zweiten Hochfrequenzabbildung erzeugt werden, erfolgt vorzugsweise zweidimensional. Dabei ist gemäß dem Anspruch 7 vorzugsweise eine Hochfrequenz-Antennenanordnung mit mehreren Antennen vorgesehen, die das Leistungsmodul in Zeilen und Spalten abscannt, wobei jede Antenne wechselweise als Sender und Empfänger dient oder fungiert und dabei die Dauer für das Fungieren/Dienen als Empfänger ein von der Anzahl von Antennen in der Hochfrequenz-Antennenanordnung abhängiges Vielfaches der Dauer für das Fungieren/Dienen als Sender ist. Die Hochfrequenz-Antennenanordnung ist gemäß Anspruch 8 vorzugsweise als Antennenarray oder als T-förmige Anordnung ausgebildet. In der Sendeantennen-Funktion werden Hochfrequenzsignale drahtlos in das Leistungsmodul eingekoppelt und in der Empfangsantennen-Funktion werden die Reflexionssignale mit mehreren Antennen gemessen. Das gemessene Reflexionsverhalten verändert sich durch thermomechanische Risseinleitungen in den Bonddrähten und Lötungen im elektrischen Betrieb des Leistungsmoduls. Durch Einstrahlung und Detektion mit dem Array von Antennen lässt sich die jeweilige Hochfrequenzabbildung des Leistungsmoduls im Mikro- oder Millimeterwellenbereich erzeugen.

Mit der mathematischen Methode zur Bildrekonstruktion lassen sich aus den an der HF-Antennenanordnung empfangenen Reflexionssignalen im kombinierten Frequenzband des Ultraschalls die Hochfrequenzabbildungen errechnen.

Beim zweidimensionalen Abscannen werden die Veränderungen in den Hochfrequenzabbildungen gemäß den Ansprüchen 2 und 9 vorzugsweise als Differenzabbildung dargestellt, mit Ort und Umfang eines Schadens oder einer Delamination an dem Bauteil bzw. dem Leistungsmodul selektiv quantifiziert werden kann. So heben sich die gealterten Bereiche an dem Bauteil bzw. dem Leistungsmodul mit zunehmender Alterung von den Bereichen ohne lokale Schädigungen ab.

Der Schaden oder die Delamination an dem Bauteil bzw. dem Leistungsmodul wird dabei vorzugsweise gemäß den Ansprüchen 3 und 10 durch maximale Amplituden in der Differenzabbildung indiziert.

Langfristige Veränderungen an dem Bauteil bzw. dem Leistungsmodul lassen sich wegen der dauerhaften Drift von Radarsystemen im Mikrowellen- oder Millimeterwellenbereich nur mit erheblichem Aufwand erkennen. Durch die Kombination aus Ultraschallsignal-Einstrahlung und der Hochfrequenzsignal-Einstrahlung im Mikro- oder Millimeterwellenbereich ist eine unmittelbare Detektion von alterungsbedingten Schäden oder Delaminationen an Bauteilen, insbesondere Leistungsmodulen, möglich. Die Drift des HF-Messsystems, auch als Radarsystem bezeichnet, muss nicht aufwendig korrigiert werden, da zeitlich unmittelbar aufeinanderfolgende HF-Messungen mit und ohne Ultraschall verglichen werden. Die Anforderungen an das HF-System und der Messelektronik sind weitaus geringer als bei driftkorrigierten Aufbauten. Durch eine selektive Hochfrequenzabbildung der Schäden oder Delaminationen kann eine weitaus höhere Messgenauigkeit und Dynamik des Messverfahrens erzielt werden. Außerdem ist zur Lebensdauerüberwachung des Bauteils bzw. Leistungsmoduls über Zeiträume von vielen Jahren bis Jahrzehnte keine aufwendige Driftkorrektur mehr erforderlich, wobei die Überwachung vorzugsweise in periodischen Abständen des gealterten Leistungsmoduls erfolgt.

Weitere Vorteile der Erfindung ergeben sich aus der nachfolgenden Beschreibung eines Ausführungsbeispiels der Erfindung anhand der einzigen FIGUR

Diese zeigt eine Vorrichtung VG zur Detektion von alterungsbedingten Schäden oder Delaminationen an einem Leistungsmodul LM für ein leistungselektronisches Gerät LEG. Anstelle des Leistungsmoduls LM kann aber auch jedes andere Bauteil BT hinsichtlich des Auftretens von alterungsbedingten Schäden oder Delaminationen untersucht und dabei die auftretenden alterungsbedingten Schäden oder Delaminationen detektiert werden. Das Leistungselektronisches Gerät LEG ist beispielsweise ein Umrichter, in dem die nachfolgend näher beschriebene Vorrichtung VG enthalten ist.

Die Vorrichtung VG enthält eine zum Senden und Empfangen von Signalen ausgebildete Hochfrequenz-Antennenanordnung HFAO, die im Zuge von Hochfrequenzreflektometrie das Leitungsmodul LM, BT durch Hochfrequenzsignal-Einstrahlung im Mikro- oder Millimeterwellenbereich und durch Messen von mindestens einem an dem Leitungsmodul LM, BT infolge der Hochfrequenzsignal-Einstrahlung reflektierten Reflexionssignal RSI punktuell, eindimensional oder zweidimensional abscannt. Die Hochfrequenzsignal-Einstrahlung erfolgt auf der Basis von durch eine Hochfrequenzsignaleinrichtung HFSE gelieferten Hochfrequenzsignalen. Die Hochfrequenzsignaleinrichtung HFSE kann dabei - wie in der FIGUR dargestellt - Bestandteil der Vorrichtung VG sein oder aber auch alternativ dieser extern zugeordnet sein.

Die Anzahl von in der Hochfrequenz-Antennenanordnung HFAO für das Senden und Empfangen der Signale enthaltenen Antennen ist abhängig von der Art wie das Abscannen letztlich erfolgen soll.

Für ein punktuelles Abscannen wären wenigstens zwei Antennen erforderlich, eine die als Sendeantenne dient, während die andere als Empfangsantenne fungiert. Über die Sendeantenne erfolgte eine Hochfrequenzsignal-Einstrahlung im Mikro- oder Millimeterwellenbereich an dem Leitungsmodul LM, BT und über die Empfangsantenne würde ein an dem Leitungsmodul LM, BT infolge der Hochfrequenzsignal-Einstrahlung reflektiertes Reflexionssignal RSI gemessen. Danach käme es zu einem Antennenwechsel, die von Sendeantenne wird zur Empfangsantenne und die Empfangsantenne zur Sendeantenne.

Für ein eindimensionales Abscannen würde eine Vielzahl von Antennen benötigt, die in einer Reihe angeordnet sind, wobei jede Antenne in dieser Reihe wechselweise als Sender und Empfänger dient oder fungiert und dabei die Dauer für das Fungieren/Dienen als Empfänger ein von der Anzahl von Antennen, die in der Hochfrequenz-Antennenanordnung HFAO in Reihe angeordnet sind, abhängiges Vielfaches der Dauer für das Fungieren/Dienen als Sender ist.

Wie dieses von der Dauer unterschiedliche, wechselweise Dienen oder Fungieren als Sender und Empfänger in einer bevorzugten Ausprägung des Ausführungsbeispiels ganz allgemein funktioniert, soll im Folgenden anhand in der FIGUR dargestellte Hochfrequenz-Antennenanordnung HFAO mit einem Antennenarray, enthaltend eine Vielzahl von Antennen Aₓ₁...Aₓ₈ und A_{y1}...A_{y8}, für das zweidimensionale Abscannen beschrieben werden. Alternativ anstelle der Ausgestaltung als Antennenarray kann die Hochfrequenz-Antennenanordnung HFAO auch als T-förmige Anordnung ausgebildet sein. Beim zweidimensionalen Abscannen wird das Leitungsmodul LM, BT in Zeilen und Spalten abgescannt, wobei wieder jede Antenne wechselweise als Sender und Empfänger dient oder fungiert und dabei - wie sich nachfolgend zeigen wird - die Dauer für das Fungieren/Dienen als Empfänger ein von der Anzahl von Antennen in der Hochfrequenz-Antennenanordnung HFAO abhängiges Vielfaches der Dauer für das Fungieren/Dienen als Sender ist.

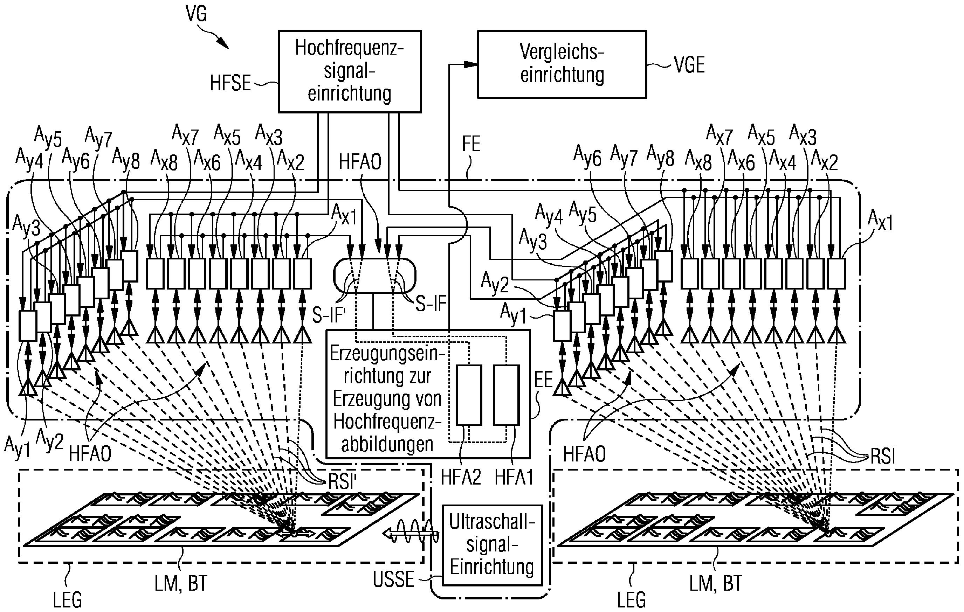

In dem in der FIGUR 1 dargestellten Fall erfolgt in einem ersten Abscannen-Schritt über die Antenne Aₓ₁ eine erste Hochfrequenzsignal-Einstrahlung im Mikro- oder Millimeterwellenbereich an dem Leitungsmodul LM, BT und über die anderen Antennen Aₓ₂...A_{xB} und A_{y1}...A_{y8} werden die an dem Leitungsmodul LM, BT infolge der Hochfrequenzsignal-Einstrahlung reflektierten Reflexionssignale RSI gemessen. Danach werden für einen zweiten Abscannen-Schritt Antennenwechsel vorgenommen, die Antenne Aₓ₁ wird zur Empfangsantenne und die Antenne Aₓ₂ wird zur Sendeantenne. In dem zweiten Abscannen-Schritt erfolgt über die Antenne Aₓ₂ eine zweite Hochfrequenzsignal-Einstrahlung im Mikro- oder Millimeterwellenbereich an dem Leitungsmodul LM, BT und über die anderen Antennen Aₓ₁, Aₓ₃...Aₓ₈ und A_{y1}...A_{y8} werden die an dem Leitungsmodul LM, BT infolge der Hochfrequenzsignal-Einstrahlung reflektierten Reflexionssignale RSI gemessen. Nach diesem Prinzip wird jede Antenne der Antennen Aₓ₁...Aₓ₈ und A_{y1}...A_{y8} mal Sendeantenne, während jeweils alle anderen Antennen Empfangsantennen sind. Aus diesen von der Hochfrequenz-Antennenanordnung HFAO gemessenen Reflexionssignale RSI werden Scan-Informationen S-IF gebildet.

Die Vorrichtung VG enthält nun des Weiteren eine Erzeugungseinrichtung EE zur Erzeugung von Hochfrequenzabbildungen, die mit der Hochfrequenz-Antennenanordnung HFAO verbunden ist. An diese Erzeugungseinrichtung EE werden die Scan-Informationen von der Hochfrequenz-Antennenanordnung HFAO weitergegeben. In der Erzeugungseinrichtung EE wird auf der Basis von durch die Hochfrequenz-Antennenanordnung HFAO gelieferten Scan-Informationen S-IF mindestens eine erste Hochfrequenzabbildung HFA1 erzeugt. Diese Erzeugung der ersten Hochfrequenzabbildung HFA1 passiert vorzugsweise auf der Basis von mathematischen Methoden zur Bildrekonstruktion.

Weiterhin ist in der Vorrichtung VG eine Ultraschallsignal-Einrichtung USSE enthalten, die mit der Hochfrequenz-Antennenanordnung HFAO und der Erzeugungseinrichtung EE eine Funktionseinheit FE bildet. Die Ultraschallsignal-Einrichtung USSE enthält vorzugsweise mindestens eine Sonotrode.

Die gebildete Funktionseinheit FE ist was deren Funktion anbetrifft derart ausgebildet, dass das Leitungsmodul LM, BT unmittelbar zeitversetzt zur vorstehend beschriebenen Hochfrequenzsignal-Einstrahlung - will heißen, das direkt nach der Hochfrequenzsignal-Einstrahlung im Mikro- oder Millimeterwellenbereich und dem durch Messen der Reflexionssignal RSI zweidimensionalen Abscannen des Leitungsmoduls LM, BT zur Erzeugung der ersten Hochfrequenzabbildung HFA1 - durch eine Kombination aus Ultraschallsignal-Einstrahlung, die durch die Ultraschallsignal-Einrichtung USSE eingestrahlt wird, und der Hochfrequenzsignal-Einstrahlung im Mikro- oder Millimeterwellenbereich, wie sie vorstehend beschrieben worden ist, sowie durch Messen von mindestens einem weiteren, an dem Leitungsmodul LM, BT infolge der Kombination aus der Ultraschallsignal- und Hochfrequenzsignal-Einstrahlung reflektierten Reflexionssignal RSI' punktuell, eindimensional oder zweidimensional abgescannt wird.

Die Ultraschallsignal-Einstrahlung erfolgt über die Sonotrode unmittelbar im Bodenbereich des Leistungsmoduls LM.

Das Abscannen erfolgt analog zu dem bei der alleinigen, zuvor beschriebenen Hochfrequenzsignal-Einstrahlung im Mikro- oder Millimeterwellenbereich. Aus den dabei von der Hochfrequenz-Antennenanordnung HFAO gemessenen weiteren Reflexionssignale RSI' werden weitere Scan-Informationen S-IF` gebildet. Diese werden wieder von der Hochfrequenz-Antennenanordnung HFAO an die Erzeugungseinrichtung EE weitergegeben. In der Erzeugungseinrichtung EE wird auf der Basis von durch die Hochfrequenz-Antennenanordnung HFAO gelieferten weiteren Scan-Informationen mindestens eine zweite Hochfrequenzabbildung HFA2 erzeugt. Auch die Erzeugung der zweiten Hochfrequenzabbildung HFA1 passiert vorzugsweise auf der Basis von mathematischen Methoden zur Bildrekonstruktion.

Abschließend enthält die Vorrichtung VG noch eine Vergleichseinrichtung VGE, die mit der Erzeugungseinrichtung EE verbunden ist und mit der Funktionseinheit FE in der Weise funktional zusammenwirkt, dass die auf der Grundlage der Reflexionssignale RSI, RSI` erzeugten Hochfrequenzabbildungen HFA1, HFA2 verglichen werden, wobei festgestellte Veränderungen in den Hochfrequenzabbildungen HFA1, HFA2 Schäden oder Delaminationen an dem Leitungsmodul LM, BT indizieren.

Dieses Vergleichen kann dabei vorzugsweise so aussehen, dass beim zweidimensionalen Abscannen die in den Hochfrequenzabbildungen HFA1, HFA2 festgestellten Veränderungen in einer Differenzabbildung dargestellt werden, mit der Ort und Umfang eines Schadens oder einer Delamination an dem Leitungsmodul LM, BT angegeben werden. So kann z.B. der Schaden oder die Delamination an dem Leitungsmodul LM, BT durch maximale Amplituden in der Differenzabbildung indiziert werden. Mit anderen Worten: Es liegt ein Schadensindikator vor, mit dem aus den maximalen lokalen Amplituden des Differenzbildes der Schaden bestimmt werden kann.

## Patentansprüche

1. Verfahren zur Detektion von alterungsbedingten Schäden oder Delaminationen an Bauteilen, insbesondere Leistungsmodulen leistungselektronischer Geräte, bei dem im Zuge von Hochfrequenzreflektometrie ein Bauteil (BT), insbesondere ein Leistungsmodul (LM), durch Hochfrequenzsignal-Einstrahlung im Mikro- oder Millimeterwellenbereich und durch Messen von mindestens einem an dem Bauteil (BT,LM) infolge der Hochfrequenzsignal-Einstrahlung reflektierten Reflexionssignal (RSI) punktuell, eindimensional oder zweidimensional zur Erzeugung, insbesondere auf der Basis von mathematischen Methoden zur Bildrekonstruktion, von mindestens einer ersten Hochfrequenzabbildung (HFA1) abgescannt wird,
**dadurch gekennzeichnet, dass**
**a**) das Bauteil (BT, LM) unmittelbar zeitversetzt zur Hochfrequenzsignal-Einstrahlung durch eine Kombination aus Ultraschallsignal-Einstrahlung und der Hochfrequenzsignal-Einstrahlung im Mikro- oder Millimeterwellenbereich sowie durch Messen von mindestens einem weiteren, an dem Bauteil (BT,LM) infolge der Ultraschallsignal- und Hochfrequenzsignal-Einstrahlung reflektierten Reflexionssignal (RSI') punktuell, eindimensional oder zweidimensional zur Erzeugung von mindestens einer zweiten Hochfrequenzabbildung (HFA2) abgescannt wird,
**b**) die auf der Grundlage der Reflexionssignale (RSI, RSI') erzeugten Hochfrequenzabbildungen (HFA1, HFA2) verglichen werden, wobei festgestellte Veränderungen in den Hochfrequenzabbildungen (HFA1, HFA2) Schäden oder Delaminationen am Bauteil (BT, LM) indizieren.

2. Verfahren nach Anspruch 1, **dadurch gekennzeichnet, dass**
beim zweidimensionalen Abscannen mit einer die Veränderungen in den Hochfrequenzabbildungen (HFA1, HFA2) darstellenden Differenzabbildung Ort und Umfang eines Schadens oder einer Delamination an dem Bauteil (BT, LM) angegeben werden.

3. Verfahren nach Anspruch 2, **dadurch gekennzeichnet, dass**
der Schaden oder die Delamination an dem Bauteil (BT, LM) durch maximale Amplituden in der Differenzabbildung indiziert wird.

4. Verfahren nach einem der Ansprüche 1 bis 3, **dadurch gekennzeichnet, dass**
mindestens eine Sonotrode für die Ultraschallsignal-Einstrahlung benutzt wird.

5. Verfahren nach Anspruch 4, **dadurch gekennzeichnet, dass**
die Ultraschallsignal-Einstrahlung, wenn das Bauteil (BT, LM) das Leistungsmodul (LM) ist, unmittelbar im Bodenbereich des Leistungsmoduls (LM) eingestrahlt wird.

6. Vorrichtung (VG) zur Detektion von alterungsbedingten Schäden oder Delaminationen an Bauteilen, insbesondere Leistungsmodulen leistungselektronischer Geräte, mit
- einer zum Senden und Empfangen ausgebildeten Hochfrequenz-Antennenanordnung (HFAO), die ausgebildet ist, im Zuge von Hochfrequenzreflektometrie ein Bauteil (BT), insbesondere ein Leitungsmodul (LM), durch Hochfrequenzsignal-Einstrahlung im Mikro- oder Millimeterwellenbereich und durch Messen von mindestens einem an dem Bauteil (BT,LM) infolge der Hochfrequenzsignal-Einstrahlung reflektierten Reflexionssignal (RSI) punktuell, eindimensional oder zweidimensional abzuscannen, sowie
- einer Erzeugungseinrichtung (EE) zur Erzeugung von Hochfrequenzabbildungen, die ausgebildet ist, insbesondere basierend auf mathematischen Methoden zur Bildrekonstruktion, auf der Basis von durch die Hochfrequenz-Antennenanordnung (HFAO) gelieferten Scan-Informationen (S-IF) mindestens eine erste Hochfrequenzabbildung (HFA1) zu erzeugen,
**gekennzeichnet durch**
**a**) eine Ultraschallsignal-Einrichtung (USSE), die mit der Hochfrequenz-Antennenanordnung (HFAO) und der Erzeugungseinrichtung (EE) eine Funktionseinheit (FE) bildet und wobei diese Funktionseinheit (FE) derart ausgebildet ist, dass das Bauteil (BT, LM) unmittelbar zeitversetzt zur Hochfrequenzsignal-Einstrahlung durch eine Kombination aus Ultraschallsignal-Einstrahlung, eingestrahlt durch die Ultraschallsignal-Einrichtung (USSE), und der Hochfrequenzsignal-Einstrahlung im Mikro- oder Millimeterwellenbereich sowie durch Messen von mindestens einem weiteren, an dem Bauteil (BT,LM) infolge der Ultraschallsignal- und Hochfrequenzsignal-Einstrahlung reflektierten Reflexionssignal (RSI') punktuell, eindimensional oder zweidimensional abgescannt und auf der Basis von durch die Hochfrequenz-Antennenanordnung (HFAO) gelieferten weiteren Scan-Informationen (S-IF') mindestens eine zweite Hochfrequenzabbildung (HFA2) erzeugt werden,
**b**) eine Vergleichseinrichtung (VGE), die mit der Funktionseinheit (FE) in der Weise funktional zusammenwirkt, dass die auf der Grundlage der Reflexionssignale (RSI, RSI') erzeugten Hochfrequenzabbildungen (HFA1, HFA2) verglichen werden, wobei festgestellte Veränderungen in den Hochfrequenzabbildungen (HFA1, HFA2) Schäden oder Delaminationen am Bauteil (BT, LM) indizieren.

7. Vorrichtung (VG) nach Anspruch 6, **dadurch gekennzeichnet, dass**
die Hochfrequenz-Antennenanordnung (HFAO) derart ausgebildet ist, dass beim zweidimensionalen Abscannen das Bauteil (BT, LM) in Zeilen und Spalten abgescannt wird, wobei jede Antenne wechselweise als Sender und Empfänger dient oder fungiert, wobei die Dauer für das Fungieren/Dienen als Empfänger ein von der Anzahl von Antennen in der Hochfrequenz-Antennenanordnung (HFAO) abhängiges Vielfaches der Dauer für das Fungieren/Dienen als Sender ist.

8. Vorrichtung (VG) nach Anspruch 7, **dadurch gekennzeichnet, dass**
die Hochfrequenz-Antennenanordnung (HFAO) als Antennenarray oder als T-förmige Anordnung ausgebildet ist.

9. Vorrichtung (VG) nach einem der Ansprüche 6 bis 8, **dadurch gekennzeichnet, dass**
die aus der Ultraschallsignal-Einrichtung (USSE) und der Hochfrequenz-Antennenanordnung (HFAO) gebildete Funktionseinheit (FE) und die Vergleichseinrichtung (VGE) derart ausgebildet sind, dass
beim zweidimensionalen Abscannen mit einer die Veränderungen in den Hochfrequenzabbildungen (HFA1, HFA2) darstellenden Differenzabbildung Ort und Umfang eines Schadens oder einer Delamination an dem Bauteil (BT, LM) angegeben werden.

10. Vorrichtung (VG) nach Anspruch 9, **dadurch gekennzeichnet, dass**
die aus der Ultraschallsignal-Einrichtung (USSE) und der Hochfrequenz-Antennenanordnung (HFAO) gebildete Funktionseinheit (FE) und die Vergleichseinrichtung (VGE) derart ausgebildet sind, dass
der Schaden oder die Delamination an dem Bauteil (BT, LM) durch maximale Amplituden in der Differenzabbildung indiziert wird.

11. Vorrichtung (VG) nach einem der Ansprüche 6 bis 10, **dadurch gekennzeichnet, dass**
die aus der Ultraschallsignal-Einrichtung (USSE) mindestens eine Sonotrode enthält.

12. Vorrichtung (VG) nach Anspruch 11, **dadurch gekennzeichnet, dass**
die Sonotrode derart ausgebildet ist, dass die Ultraschallsignal-Einstrahlung, wenn das Bauteil (BT, LM) das Leistungsmodul (LM) ist, unmittelbar im Bodenbereich des Leistungsmoduls (LM) eingestrahlt wird.

13. Leistungselektronisches Gerät (LEG), insbesondere Umrichter, **gekennzeichnet durch**
eine Vorrichtung (VG) nach einem der Ansprüche 6 bis 12, die das Verfahren nach einem der Ansprüche 1 bis 5 durchführt.

## Claims

1. Method for detecting aging-dictated damage or delamination on components, in particular power modules of power electronic devices, in which, in the course of radiofrequency reflectometry, a component (BT), in particular a power module (LM), is scanned by radiofrequency signal irradiation in the microwave or millimeter-wave range and by measurement of at least one reflection signal (RSI), which was reflected at the component (BT,LM) as a consequence of the radiofrequency signal irradiation, in punctiform, one-dimensional or two-dimensional fashion for the purpose of generating at least one first radiofrequency image representation (HFA1), in particular on the basis of mathematical methods for image reconstruction, **characterized in that**
**a**) the component (BT, LM) is scanned directly with a time offset with respect to the radiofrequency signal irradiation by a combination of ultrasonic signal irradiation and the radiofrequency signal irradiation in the microwave or millimeter-wave range and by measurement of at least one further reflection signal (RSI'), which was reflected at the component (BT,LM) as a consequence of the ultrasonic signal irradiation and radiofrequency signal irradiation, in punctiform, one-dimensional or two-dimensional fashion for the purpose of generating at least one second radiofrequency image representation (HFA2),
**b)** the radiofrequency image representations (HFA1, HFA2) generated on the basis of the reflection signals (RSI, RSI') are compared, wherein ascertained changes in the radiofrequency image representations (HFA1, HFA2) indicate damage or delamination on the component (BT, LM).

2. Method according to Claim 1, **characterized in that** location and extent of damage or delamination on the component (BT, LM) are specified during two-dimensional scanning with a difference image representation representing the changes in the radiofrequency image representations (HFA1, HFA2).

3. Method according to Claim 2, **characterized in that** the damage or delamination on the component (BT, LM) is indicated by maximum amplitudes in the difference image representation.

4. Method according to any of Claims 1 to 3, **characterized in that**
at least one sonotrode is used for the ultrasonic signal irradiation.

5. Method according to Claim 4, **characterized in that** if the component (BT, LM) is the power module (LM), the ultrasonic signal irradiation is radiated in directly in the bottom region of the power module (LM).

6. Apparatus (VG) for detecting aging-dictated damage or delamination on components, in particular power modules of power electronic devices, comprising
- a radiofrequency antenna arrangement (HFAO) configured for transmitting and receiving, which is configured to scan, in the course of radiofrequency reflectometry, a component (BT), in particular a power module (LM), by radiofrequency signal irradiation in the microwave or millimeter-wave range and by measurement of at least one reflection signal (RSI), which was reflected at the component (BT,LM) as a consequence of the radiofrequency signal irradiation, in punctiform, one-dimensional or two-dimensional fashion, and also
- a generating device (EE) for generating radiofrequency image representations, which is configured to generate at least one first radiofrequency image representation (HFA1), in particular on the basis of mathematical methods for image reconstruction, on the basis of scan information (S-IF) supplied by the radiofrequency antenna arrangement (HFAO),
**characterized by**
**a**) an ultrasonic signal device (USSE), which together with the radiofrequency antenna arrangement (HFAO) and the generating device (EE) forms a functional unit (FE) and wherein said functional unit (FE) is configured in such a way that the component (BT, LM) is scanned directly with a time offset with respect to the radiofrequency signal irradiation by a combination of ultrasonic signal irradiation, radiated in by the ultrasonic signal device (USSE), and the radiofrequency signal irradiation in the microwave or millimeter-wave range and by measurement of at least one further reflection signal (RSI'), which was reflected at the component (BT,LM) as a consequence of the ultrasonic signal irradiation and radiofrequency signal irradiation, in punctiform, one-dimensional or two-dimensional fashion, and at least one second radiofrequency image representation (HFA2) is generated on the basis of further scan information (S-IF') supplied by the radiofrequency antenna arrangement (HFAO),
**b**) a comparison device (VGE), which functionally interacts with the functional unit (FE) in such a way that the radiofrequency image representations (HFA1, HFA2) generated on the basis of the reflection signals (RSI, RSI') are compared, wherein ascertained changes in the radiofrequency image representations (HFA1, HFA2) indicate damage or delamination on the component (BT, LM).

7. Apparatus (VG) according to Claim 6, **characterized in that** the radiofrequency antenna arrangement (HFAO) is configured in such a way that during two-dimensional scanning the component (BT, LM) is scanned in rows and columns, wherein each antenna serves or functions alternately as transmitter and receiver, wherein the duration for functioning/serving as receiver is a multiple of the duration for functioning/serving as transmitter, said multiple being dependent on the number of antennas in the radiofrequency antenna arrangement (HFAO).

8. Apparatus (VG) according to Claim 7, **characterized in that** the radiofrequency antenna arrangement (HFAO) is configured as an antenna array or as a T-shaped arrangement.

9. Apparatus (VG) according to any of Claims 6 to 8, **characterized in that**
the functional unit (FE) formed from the ultrasonic signal device (USSE) and the radiofrequency antenna arrangement (HFAO), and the comparison device (VGE) are configured in such a way that
location and extent of damage or delamination on the component (BT, LM) are specified during two-dimensional scanning with a difference image representation representing the changes in the radiofrequency image representations (HFA1, HFA2).

10. Apparatus (VG) according to Claim 9, **characterized in that** the functional unit (FE) formed from the ultrasonic signal device (USSE) and the radiofrequency antenna arrangement (HFAO), and the comparison device (VGE) are configured in such a way that
the damage or delamination on the component (BT, LM) is indicated by maximum amplitudes in the difference image representation.

11. Apparatus (VG) according to any of Claims 6 to 10, **characterized in that**
the ultrasonic signal device (USSE) contains at least one sonotrode.

12. Apparatus (VG) according to Claim 11, **characterized in that** the sonotrode is configured in such a way that if the component (BT, LM) is the power module (LM), the ultrasonic signal irradiation is radiated in directly in the bottom region of the power module (LM).

13. Power electronic device (LEG), in particular converter, **characterized by**
an apparatus (VG) according to any of Claims 6 to 12 which carries out the method according to any of Claims 1 to 5.

## Revendications

1. Procédé de détection de détériorations dues au vieillissement ou de délaminations de composants, en particulier de modules de puissance d'appareils d'électronique de puissance, dans lequel, au cours d'une réflectométrie en haute fréquence, on scanne ponctuellement, monodimensionnellement ou bidimensionnellement pour la production, en particulier sur la base de méthodes mathématiques de reconstruction d'images, d'au moins une première représentation (HFA1) en haute fréquence, un composant (BT), en particulier un module (LM) de puissance, par rayonnement incident de signal en haute fréquence, dans le domaine d'ondes du micron ou du millimètre et par mesure d'au moins un signal (RSI) de réflexion, réfléchi sur le composant (BT, LM) en raison du rayonnement incident de signal en haute fréquence, **caractérisé en ce que**
**a)** l'on scanne ponctuellement, monodimensionnellement ou bidimensionnellement, pour la production d'au moins une deuxième représentation (HFA2) en haute fréquence, le composant (BT, LM) d'une manière décalée dans le temps immédiatement pour le rayonnement incident de signal en haute fréquence, par une combinaison de rayonnement incident de signal d'ultrasons et de rayonnement incident de signal de haute fréquence dans le domaine d'ondes du micron ou du millimètre, ainsi que par mesure d'au moins un autre signal (RSI') de réflexion, réfléchi sur le composant (BT, LM) en raison du rayonnement incident de signal d'ultrasons et du rayonnement incident de signal de haute fréquence,
**b)** l'on compare les représentations (HFA1, HFA2) en haute fréquence produites sur la base des signaux (RSI, RSI') de réflexion des modifications constatées dans les représentations (HFA1, HFA2) en haute fréquence étant l'indice de détériorations ou de délaminations sur le composant (BT, LM).

2. Procédé suivant la revendication 1, **caractérisé en ce que**, lors du scan en deux dimensions, avec une formation de différence représentant les modifications dans les représentations (HFA1, HFA2) en haute fréquence, on indique l'emplacement et l'étendue d'une détérioration ou d'une délamination sur le composant (BT, LM) .

3. Procédé suivant la revendication 2, **caractérisé en ce que** l'on donne, comme indices de la détérioration ou de la délamination du composant (BT, LM), des amplitudes maximum dans la représentation de différence.

4. Procédé suivant l'une des revendications 1 à 3, **caractérisé en ce que**
l'on utilise au moins une sonotrode pour le rayonnement incident de signal d'ultrasons.

5. Procédé suivant la revendication 4, **caractérisé en ce que** l'on rayonne le rayonnement incident de signal d'ultrasons, si le composant (BT, LM) est le module (LM) de puissance, directement dans la partie de fond du module (LM) de puissance.

6. Installation (VG) de détection de détériorations dues au vieillissement ou de délaminations sur des composants, en particulier des modules de puissance d'appareils d'électronique de puissance, comprenant
- un agencement (HFAO) d'antennes en haute fréquence constitué pour l'émission et la réception, qui est constitué pour scanner ponctuellement, monodimensionnellement ou bidimensionnellement, au cours d'une réflectométrie en haute fréquence, un composant (BT), en particulier un module (LM) de puissance, par rayonnement incident de signal en haute fréquence dans le domaine d'ondes du micron ou du millimètre et par mesure d'au moins un signal (RSI) de réflexion réfléchi sur le composant (BT, LM) en raison du rayonnement incident de signal en haute fréquence, ainsi que
- un dispositif (EE) de production pour la production de représentations en haute fréquence, qui est constitué pour produire au moins une première représentation (HFA1) en haute fréquence, en particulier sur la base de méthodes mathématiques de reconstruction d'images, sur la base d'informations (S-IF) de scan fournies par l'agencement (HFAO) d'antennes en haute fréquence,
**caractérisée par**
**a)** un dispositif (USSE) de signal d'ultrasons, qui forme une unité (FE) fonctionnelle avec l'agencement (HFAO) d'antennes en haute fréquence et le dispositif (EE) de production, dans laquelle cette unité (FE) fonctionnelle est constituée de manière à ce que le composant (BT, LM) soit scanné ponctuellement, monodimensionnellement ou bidimensionnellement de façon décalée dans le temps immédiatement par rapport au rayonnement incident de signal de haute fréquence, par une combinaison de rayonnement incident du signal d'ultrasons rayonné par le dispositif (USSE) de signal d'ultrasons et du rayonnement incident de signal en haute fréquence dans le domaine d'ondes du micron ou du millimètre, ainsi que par mesure d'au moins un autre signal (RSI') de réflexion, réfléchi sur le composant (BT, LM) en raison du rayonnement incident de signal d'ultrasons et du rayonnement incident de signal de haute fréquence et de manière à produire au moins une deuxième représentation (HFA2) en haute fréquence, sur la base d'autres informations (S-IF') de scan fournies par l'agencement (HFAO) d'antennes en haute fréquence,
**b)** un dispositif (VGE) de comparaison, qui coopère fonctionnellement avec l'unité (FE) fonctionnelle, de manière à comparer les représentations (HFA1, HFA2) en haute fréquence produites sur la base des signaux (RSI, RSI') de réflexion des modifications constatées dans les représentations (HFA1, HFA2) en haute fréquence étant l'indice de détériorations ou de délaminations sur le composant (BT, LM).

7. Installation (VG) suivant la revendication 6, **caractérisée en ce que**
l'agencement (HFAO) d'antennes en haute fréquence est constitué de manière à scanner, lors du scan en deux dimensions, le composant (BT, LM) en lignes et en colonnes, dans laquelle chaque antenne sert ou fonctionne en alternance en émetteur et en récepteur, dans laquelle la durée de fonctionnement en récepteur ou dans laquelle elle sert en récepteur est un multiple, qui dépend du nombre d'antennes dans l'agencement (HFAO) d'antennes en haute fréquence, de la durée pendant laquelle elle fonctionne en émetteur ou elle sert d'émetteur.

8. Installation (VG) suivant la revendication 7, **caractérisée en ce que**
l'agencement (HFAO) d'antennes en haute fréquence est constitué sous la forme d'un réseau d'antennes ou d'un agencement en forme de T.

9. Installation (VG) suivant l'une des revendications 6 à 8, **caractérisée en ce que**
l'unité (FE) fonctionnelle formée du dispositif (USSE) de signal d'ultrasons et de l'agencement (HFAO) d'antennes en haute fréquence et le dispositif (VGE) de comparaison sont constitués de manière à ce que,
lors d'un scan en deux dimensions, on indique, par une représentation de différence représentant les modifications dans les représentations (HFA1, HFA2) en haute fréquence, un emplacement et une étendue d'une détérioration ou d'une délamination sur la pièce (BT, LM).

10. Installation (VG) suivant la revendication 9, **caractérisée en ce que**
l'unité (FE) fonctionnelle formée du dispositif (USSE) de signal d'ultrasons et de l'agencement (HFAO) d'antennes en haute fréquence et le dispositif (VGE) de comparaison sont constitués de manière à ce que
des amplitudes maximum dans la représentation de différence sont l'indice de la détérioration ou de la délamination sur le composant (BT, LM) .

11. Installation (VG) suivant l'une des revendications 6 à 10, **caractérisée en ce que**
le dispositif (USSE) de signal d'ultrasons comporte au moins une sonotrode.

12. Installation (VG) suivant la revendication 11, **caractérisée en ce que** la sonotrode est constituée de manière à ce que le rayonnement incident de signal d'ultrasons soit, si le composant (BT, LM) est le module (LM) de puissance, rayonné directement dans la partie de fond du module (LM) de puissance.

13. Appareil (LEG) d'électronique de puissance, en particulier convertisseur, **caractérisé par**
une installation (VG) suivant l'une des revendications 6 à 12, qui exécute le procédé suivant l'une des revendications 1 à 5.
